**Europäisches Patentamt**

**European Patent Office**

**Office européen des brevets**

(19)

(11) Veröffentlichungsnummer: **0 441 281 A2**

(12) **EUROPÄISCHE PATENTANMELDUNG**

(21) Anmeldenummer: **91101432.2**

(22) Anmeldetag: **04.02.91**

(51) Int. Cl.5: **G01R 33/035**

(30) Priorität: **06.02.90 DE 4003524**

(43) Veröffentlichungstag der Anmeldung:
**14.08.91 Patentblatt 91/33**

(84) Benannte Vertragsstaaten:
**CH DE FR GB IT LI**

(71) Anmelder: **Forschungszentrum Jülich GmbH**
**Postfach 1913, Wilhelm-Johnen-Strasse**
**W-5170 Jülich(DE)**

(72) Erfinder: **Heiden, Christoph, Prof. Dr.**
**Karthäuserstrasse 13**
**W-5170 Jülich(DE)**

(54) **Schaltungsanordnung mit Supraleitenden Quanten Interferenz Detektoren (SOUID).**

(57) Die Erfindung bezieht sich auf eine Schaltungsanordnung mit Supraleitenden Quanten Interferenz Detektoren (SQUID) mit Ausleseelektronik. Aufgabe der Erfindung ist es, eine Schaltungsanordnung mit SQUIDs zu schaffen, die sich durch einen geringen Pegel des Zusatzrauschens auszeichnet. Diese Aufgabe wird durch zwei parallel geschaltete Detektoren gelöst, denen eine Korrelationselektronik nachgeschaltet ist.

FIG.1a

## SCHALTUNGSANORDNUNG MIT SUPRALEITENDEN QUANTEN INTERFERENZ DETEKTOREN (SQUID)

Die Erfindung bezieht sich auf eine Schaltungsanordnung mit Supraleitenden Quanten Interferenz Detektoren mit Ausleseelektronik.

Mit der Entdeckung der Hochtemperatursupraleiter wurde es möglich, Supraleitende Quanten Intereferenz Detektoren (SQUID) mit Arbeitstemperaturen im Bereich des flüssigen Stickstoffs und darüber hinaus zu realisieren. Solche SQUID sind in verschiedenen Ausführungsformen beispielsweise als Einloch-SQUID oder als Zweiloch-SQUID-Gradiometer sowohl aus massiven Körpern wie auch in Dünnfilmtechnik hergestellt worden. Wenngleich das Eigenrauschen dieser Sensoren bei Frequenzen oberhalb ca. 100 Hz bereits attraktiv niedrige Werte annimmt, ist der Einsatz der SQUID bei niedrigen Signalfrequenzen im Bereich weniger Hertz und darunter, so bei biomagnetischen Signalen - etwa von Herz- oder Gehirnaktivität - bisher durch ein mit abnehmender Frequenz ansteigendes Zusatzrauschen beeinträchtigt.

Es ist daher Aufgabe der Erfindung, eine Schaltungsanordnung mit SQUIDs zu schaffen, die sich durch einen geringen Pegel des Zusatzrauschens auszeichnet.

Diese Aufgabe wird erfindungsgemäß dadurch erreicht, daß die Detektoren parallel geschaltet und diesen zur Verminderung von störendem Zusatzrauschen eine Korrelationselektronik nachgeschaltet ist.

Durch die in an sich bekannter Weise aufgebaute Korrelationselektronik wird das unkorrelierte Rauschen herausgemittelt, während die Nutzsignale erhalten bleiben. Dieses Prinzip kann in verschiedenen Varianten der Korrelationsanalyse eingesetzt werden, sei es durch zeitliche Mittelung (Auto- und Kreuzkorrelation) oder durch Ensemblemittelung bei einer Vielkanalanordnung. Letztere Methode ist vor allem dann von Nutzen, wenn die Zeitkonstante für die Mittelung im Vergleich zur Signalzeitkonstanten kurz sein muß, oder bei nichtperiodischen Signalen.

Insbesondere bei Hochtemperatursupraleitern ist der Empfindlichkeitsgewinn durch die Verwendung des Korrelationsverfahrens beträchtlich. Denn das durch die höhere Arbeitstemperatur der HTSL-SQUID bedingte höhere thermische Eigenrauschen stellte bisher für empfindliche Messungen, wie etwa von Gehirnsignalen, eine Barriere dar. Sie wird durch den Einsatz der Korrelationstechnik überwunden.

Auch für SQUID aus den klassischen Supraleitern bringt der Einsatz der Korrelationstechnik einen Gewinn an Empfindlichkeit, der bisher zwar erwünscht, aber nicht erreicht worden ist. Dabei finden vorteilhafterweise Ausführungen von SQUIDs Verwendung, wie sie in der deutschen Patentanmeldung P 39 31 441.3-35 beschrieben worden ist. Bei diesem als Sensor bezeichneten SQUID sind supraleitender Ring und Tankkreis ein Bauteil.

Dieses besteht aus dem Streifenresonator, wobei der Streifenresonator selbst den Tankkreis und die Begrenzung der Öffnung den supraleitenden Ring, in den das Josephsonelement inkorporiert ist, bildet. Der supraleitende Ring bildet sich somit quasi erst während des Betriebs des Sensors aus.

Dadurch, daß das Josephsonelement längs der Mittel- bzw. Längsachse des Streifenresonators liegend angeordnet ist, fließt in ihm - falls ein genügend hoher Hochfrequenzstrom eingespeist wird - der für die Messung der Magnetflüsse notwendige Strom.

Für den Betrieb des Sensors ist die Resonanzfrequenz einzuspeisen, die im Streifenresonator stehende Wellen bildet. Dies kann - bei zunächst beliebiger Länge des Streifenresonators - durch Aufsuchen bzw. Einstellen der Resonanzfrequenz geschehen. Soll jedoch mit einer bestimmten Frequenz gearbeitet werden, so ist der Streifenresonator so auszulegen, daß seine elektrische Länge $1$ einem ungeraden Vielfachen der Halbwellenlänge der Betriebsfrequenz entspricht.

Um den supraleitenden Ring mit inkorporiertem Josephsonelement möglichst günstig im Streifenresonator zu plazieren, wird er zweckmäßigerweise an einer Stelle maximalen Stromflusses im Streifenresonator angeordnet.

Es ist ferner für eine gute Ankopplung des Streifenresonators an die zum Betrieb des Sensors erforderliche Raumtemperaturelektronik zweckmäßig, daß das für diese Ankopplung vorgesehene weitere Stück Streifenleitung in der Nähe eines im Streifenresonator sich bildenden Spannungsbauches angeordnet ist.

Die bisher beschriebene Version des Sensors eignet sich in gleicher Weise wie bisher bekannte Sensoren dieser Art - allerdings mit höherer Empfindlichkeit - zur Messung der Änderung eines Magnetflusses. Dabei handelt es sich in der Regel nicht um Absolutmessungen. Vielmehr stellt man mit Sensoren dieser Art nur eine Änderung des Magnetflusses fest, entweder, indem man den Sensor bewegt oder indem man das Magnetfeld verändert. Ein - im Meßbereich - homogenes Magnetfeld ist dann daran zu erkennen, daß es keine relative Änderung des Magnetflusses zu messen gestattet.

Will man dagegen einen am Ort des Sensors inhomogenen Magnetfluß feststellen und dabei den Einfluß eines überlagernden homogenen Magnetflusses, der beispielsweise von in der Nähe befindlichen Störquellen herrühren kann, ausschalten, so bietet sich vorteilhaft eine Version des Sensors an, bei dem längs der Mittel- bzw. Längsachse des Streifenresonators hintereinander angeordnete Öffnungen mit dazwischen befindlichem Josephsonelement vorgesehen sind, wobei der Streifenresonator im Bereich der Öffnungen sowohl in Bezug auf die Öffnungen als auch in Bezug auf seine Mittel- bzw. Längsachse unsymmetrisch ausgebildet ist.

Die Unsymmetrie des Streifenresonators im Bereich der Öffnungen dient dazu, einen Hochfrequenzstrom im Josephsonelement zu erzeugen. Sie kann beispielsweise dadurch realisiert werden, daß der Streifenresonator an einer der Öffnungen oder - punktsymmetrisch um das Josephsonelement angeordnet - an beiden Öffnungen eine seitliche Aussparung und damit an dieser Stelle (an diesen Stellen) eine Verengung aufweist. In den Verengungen im Streifenresonator ist der Stromfluß ein anderer als an den von Aussparungen freien Stellen, d. h. die Stromverteilung längs der beiden Öffnungen ist unterschiedlich. Dies führt zu einem resultierenden Strom durch das Josephsonelement.

Damit ist es zugleich möglich, einen im Bereich der beiden Öffnungen inhomogenen Magnetfluß bzw. einen in diesem Meßbereich in Bezug auf die beiden Öffnungen sich unterschiedlich ändernden Magnetfluß, beispielsweise bei sich ändernden Hirnströmen, als solchen zu erkennen bzw. zu messen.

Ausgestaltungen der beschriebenen Sensoren weisen die Merkmale der Ansprüche 3 bis 7 auf.

Eine weitere Ausgestaltung des Sensors besteht ferner darin, daß bei einem als Mikrobrücke ausgebildeten Josephsonelement der Teil des Substrats unterhalb des Josephsonelements aus einem Material mit möglichst geringer Wärmeleitung besteht. Dadurch kann durch die im Josephsonelement durch Dissipation entstehende Wärme der kritische Strom des Josephsonelements auf günstigere Werte verkleinert werden, wenn die Periodendauer der Betriebsfrequenz des Sensors klein ist gegen die Zeit, in der die im Josephsonelement entstehende Wärme durch Wärmeleitung wegtransportiert werden kann.

In der Zeichnung werden die beiden Versionen des Sensors sowie die Schaltungsanordnung schematisch dargestellt und im folgenden näher erläutert:

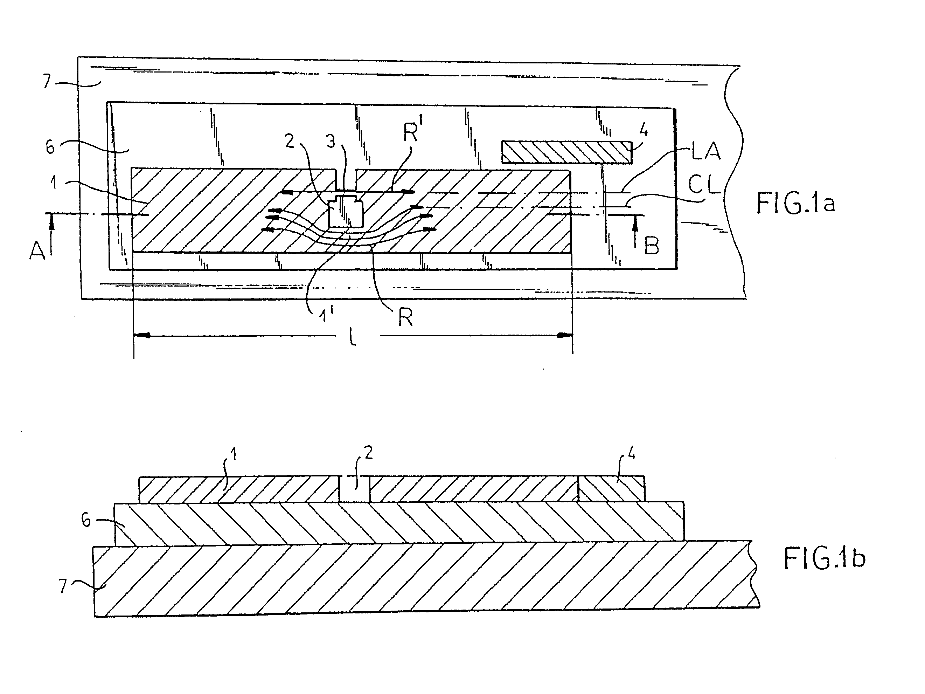

Es zeigen
Figur 1a
die Version des Sensors mit einer Öffnung;
Figur 1b
den Sensor gemäß Figur 1 im Längsschnitt längs der Linie A/B;
Figuren 2a/2aa
die Version des Sensors mit zwei Öffnungen;
Figuren 2b/2bb

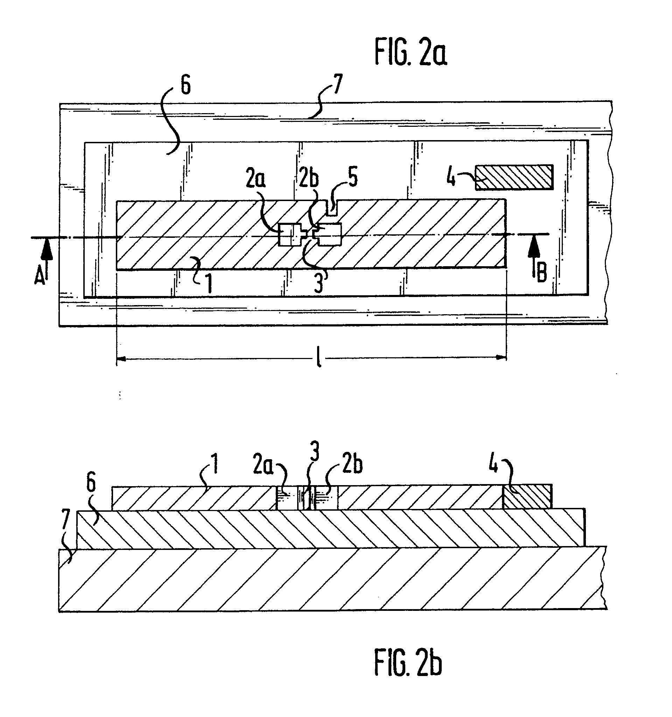

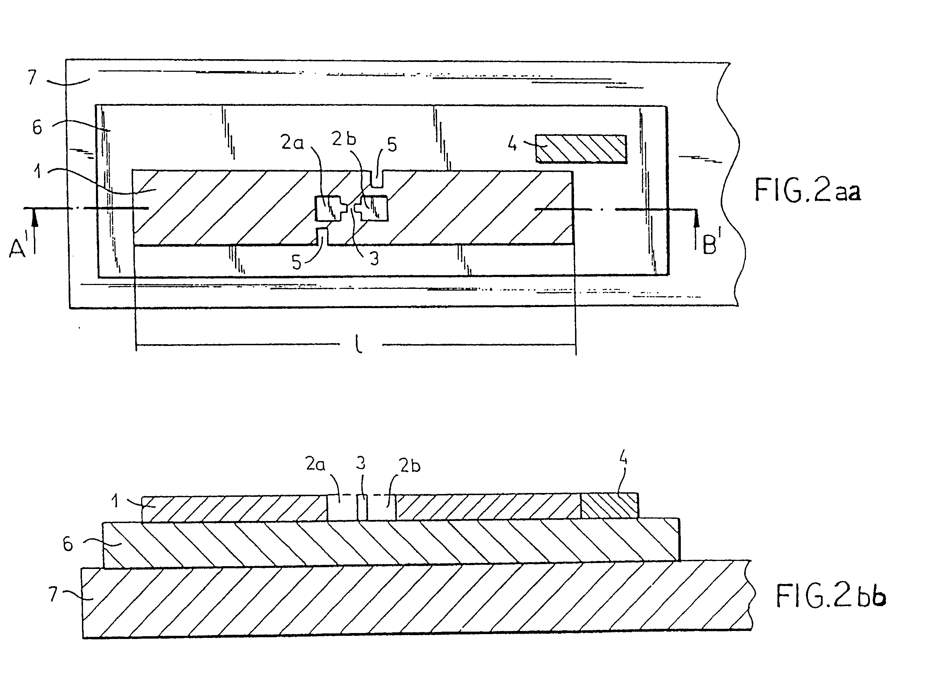

den Sensor gemäß Figuren 2a/2aa im Längsschnitt längs der Linie A/B;
Figur 3
die mechanische Halterung des Sensors mit elektrischer Kontaktierung;
Figur 4
ein Blockschaltbild der Auswerteelektronik;
Figur 5
die Schaltungsanordnung der SQUID;
Figur 6
eine einfache Korrelationsschaltung.

Die in Figur 1a dargestellte, einfache Version des Sensors besteht aus dem Streifenresonator 1 und der darin integrierten Öffnung 2. Die Ströme R und R' sind unterschiedlich groß und bedingen einen Ringstrom um die Öffnung 2, der das Josephsonelement 3 durchfließt. Dieses ist längs der Mittelachse des Streifenresonators 1 angeordnet, wobei dafür Sorge getragen ist, daß der dem Josephsonelement gegenüberliegende Teil des Streifenresonators breiter ist als das Josephsonelement.

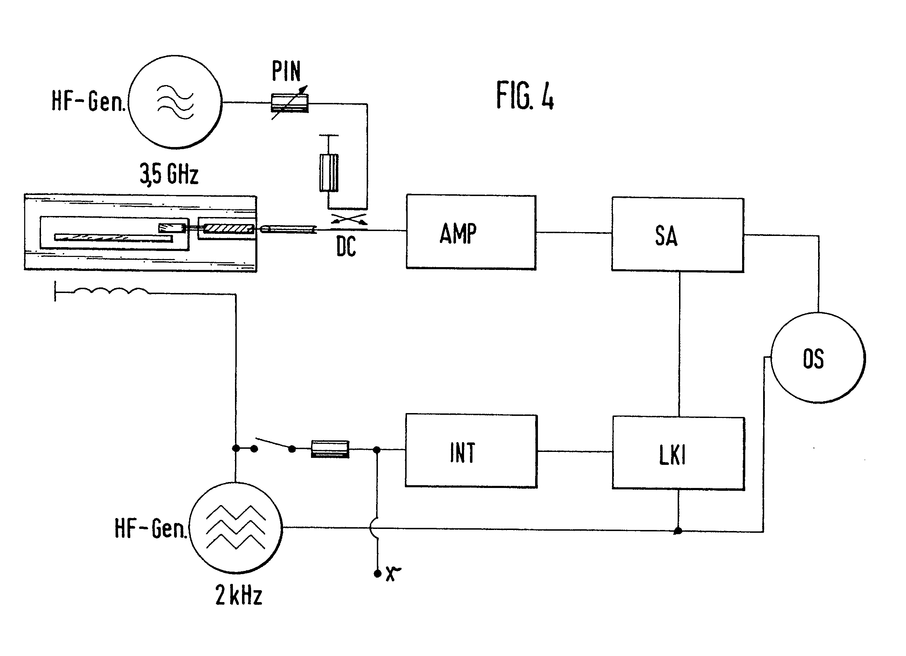

Der parallel zum Streifenresonator 1 angeordnete weitere Streifen 4 dient der kapazitiven Ankopplung des Streifenresonators an eine in Figur 4 dargestellte Auswerteelektronik.

Streifenresonator 1 und der weitere Streifen 4 sind auf einem Substrat 5 aufgebracht und dieses befindet sich auf dem Substrathalter 6.

Die Länge l des Streifenresonators ist so bemessen, daß sie einem ungeraden Vielfachen der halben Wellenlänge der Betriebsfrequenz entspricht. Das Josephsonelement ist dabei an einer Stelle maximalen Stromflusses im Streifenresonator 1 angeordnet.

Figur 1b zeigt den Sensor gemäß Figur 1 im Längsschnitt. Auf dem Substrathalter 7, der aus einem elektrisch wie thermisch gut leitenden Material (Kupfer) besteht, befindet sich das Substrat 6, das möglichst kleine dielektrische Verluste aufweist und beispielsweise aus $Al_2O_3$ (1 mm dick, 50Ω) besteht. In dem auf das Substrat 6 aufgebrachten Streifenresonator 1 aus supraleitendem Material (beispielsweise Nb, 100 mm dick) befindet sich die Öffnung 2.

Die in Figur 2a dargestellte Sensorversion besteht aus dem Streifenresonator 1, darin integrierten zwei Öffnungen 2a und 2b mit dazwischen liegendem Josephsonelement 3 sowie dem weiteren Streifen 4.

In der Nähe der Öffnung 2b weist der Streifenresonator 1 eine Aussparung 5 auf, so daß er damit sowohl in Bezug auf die Öffnungen als auch in Bezug auf seine Mittel- bzw. Längsachse unsymmetrisch ausgebildet ist. Wie weiter oben ausgeführt, ist diese Version des Sensors zur Messung inhomogener Magnetflüsse geeignet.

Figur 2aa zeigt eine punktsymmetrische Anordnung (um das Josephsonelement als "Punkt") mit zwei Aussparungen 5.

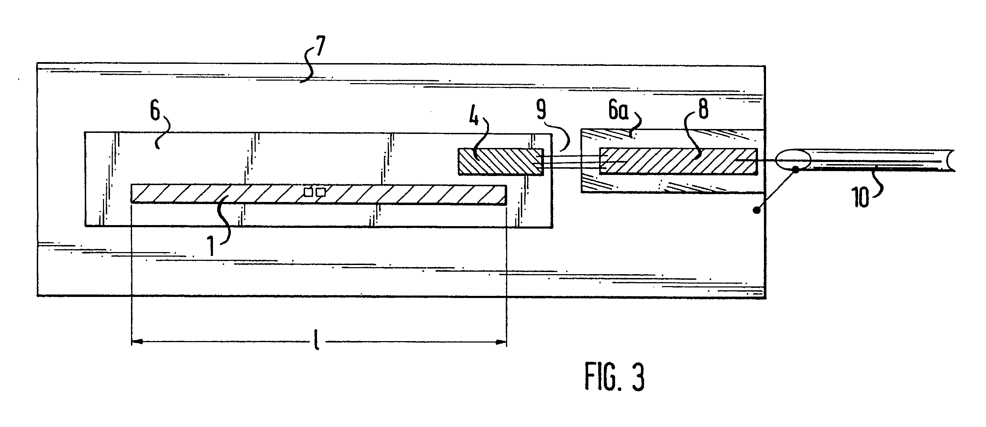

Figur 3 zeigt die mechanische Halterung des Sensors mit elektrischer Kontaktierung. Auf dem Substrathalter 7 ist über ein Substrat 6a ein weiteres Stück Streifenleitung 8 (5Ω) aufgeklebt. Das Stück Streifenleitung 4 ist durch kurze Aluminium-Bonddrähte 9 mit der Streifenleitung 8 verbunden, an die wiederum ein Koaxialkabel 10 angelötet wird, welches zur Auswerteelektronik führt.

Figur 4 zeigt ein Blockschaltbild der verwendeten Auswerteelektronik, die dem bekannten Stand der Technik entspricht. Der für den Betrieb des Sensors nötige Hochfrequenzstrom (hier 3,5 G Hz) wird von einem HF Generator erzeugt. Seine Amplitude kann durch einen Abschwächer (PIN) auf einen für den jeweiligen Sensor optimalen Wert eingestellt werden. Der Strom wird über einen Richtkoppler (DC) dem Sensor eingeprägt. Die über dem Resonator abfallende Spannung wird zunächst vorverstärkt (AMP) und mittels eines Spektrumanalysators (SA) amplituden-demoduliert. Die resultierende Niederfrequenzspannung, die die Information über den den Sensor durchdringenden magnetischen Fluß enthält, kann mittels eines Oszellographen (OS) ausgewertet werden. Zum Betrieb des Sensors in einer Flußregelschleife wird mittels eines Niederfrequenzgenerators (LF-Gen)- und einer nahe dem Sensor angebrachten Spule ein magnetischer Wechselfluß mit ca. 2 kHz in den Sensor eingeprägt. Über einen Lock-in-Verstärker (LKI) und Integrator (INT) kann auf diese Weise, wie bekannt, der magnetische Fluß durch den Sensor konstant gehalten werden.

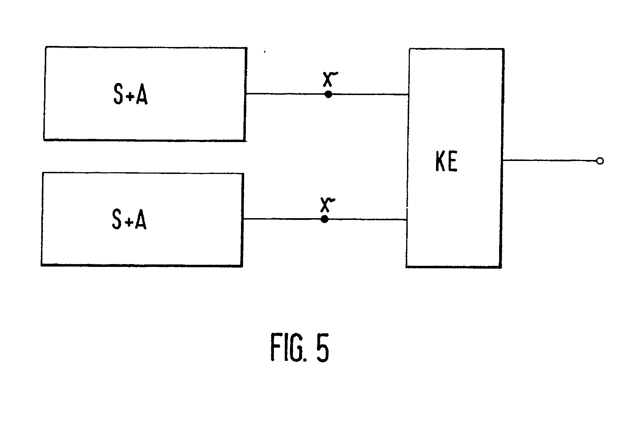

In Figur 5 ist eine Ausführungsform der Schaltungsanordnung als Druckschaltbild wiedergegeben, wobei die beiden Blöcke aus S + A dem in Figur 4 dargestellten Sensor plus Auswerteelektronik entsprechen. Die Verbindung zwischen diesen beiden Blöcken und der Korrelationselektronik KE erfolgt über das in Figur 4 wiedergegebene Leitungsstück, dessen Ende mit x angegeben ist.

Für einen Sensor nach Figur 1 wurden folgende Parameter gewählt: Das Substrat 6 bestand aus Saphir mit Abmessungen 25 x 5 x 1 mm$^3$ (B x L x D). Durch Kathodenzerstäubung wurde ein 100 mm dicker Nb Film aufgebracht und strukturiert. Die Abmessungen dieses Streifenleiterresonators 1 betrugen 20 mm Länge und 1 mm Breite. Die Öffnung 2 des Sensors betrug 40 x 40 $\mu$m$^2$. Die als Josephsonelement 3 verwendete Mikrobrücke hatte eine Breite von 150 $\mu$m und eine Länge von 3 $\mu$m. Als Substrathalter 7 wurde ein Kupferblock gewählt. Der eingespeiste Hochfrequenzstrom hatte eine Frequenz von 3,5 GHz bei einer Leistung von 40 dBm. Die flußabhängige Spannungsänderung über dem Tankkreis betrug einige hundert $\mu$V$_{pp}$ - ($\mu$V$_{peak-peak}$) an 50 Ohm.

Die Messungen wurden bei einer Temperatur des Sensors von 4,2 K durchgeführt.

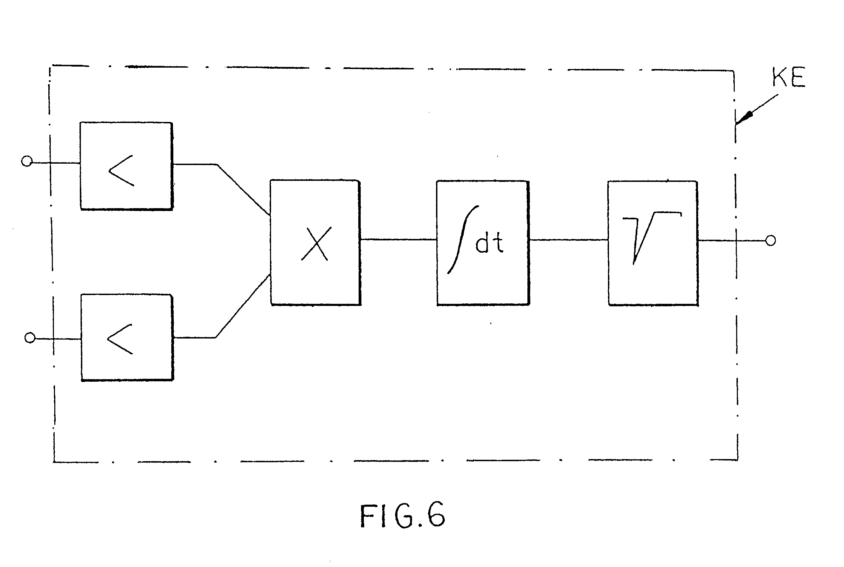

Figur 6 zeigt eine einfache Ausführungsform einer Korrelationsschaltung KE mit zwei parallelgeschalteten Verstärkern und diesen nachgeschalteten Einheiten zum Multiplizieren, zur Mittelung und zur Bildung der Quadratwurzel.

## Patentansprüche

1. Schaltungsanordnung mit Supraleitende Quanten Interferenz Detektoren (SQUID) mit Ausleseelektronik,
   **dadurch gekennzeichnet,**
   daß die Detektoren parallel geschaltet und diesen zur Verminderung von störendem Zusatzrauschen eine Korrelationselektronik nachgeschaltet ist.

2. Schaltungsanordnung nach Anspruch 1,
   **dadurch gekennzeichnet,**
   daß der Detektor aus supraleitendem Ring mit inkorporiertem Josephsonelement besteht, der an einem elektrischen Schwingkreis angekoppelt ist, wobei der elektrische Schwingkreis aus einer, einen Resonator für stehende elektrische Wellen bildenden Stück Streifenleitung (1) besteht, in der sich eine für den zu messenden Magnetfluß vorgesehene Öffnung (2) mit angrenzendem Josephsonelement (3) befindet, so daß der supraleitende Ring in den Streifenresonator (1) integriert ist, wobei das Josephsonelement längs der Mittel- bzw. Längsachse des Streifenresonators liegend angeordnet ist und daß zur kapazitiven Ankopplung des Streifenresonators (1) an eine Auswerteelektronik ein am Streifenresonator anliegendes weiteres Stück Streifenleitung (4) vorgesehen ist.

3. Schaltungsanordnung nach Anspruch 1,
   **dadurch gekennzeichnet,**
   daß der Detektor aus supraleitendem Ring mit inkorporiertem Josephsonelement besteht, der an einen elektrischen Schwingkreis angekoppelt ist, wobei der elektrische Schwingkreis aus einer, einen Resonator für stehende elektrische Wellen bildenden Stück Streifenleitung (1) besteht, in der zur Messung inhomogener Magnetflüsse zwei gleiche, längs der Mittel- bzw. Längsachse des Streifenresonators (1) hintereinander angeordnete Öffnungen (2a, 2b) mit dazwischen befindlichem Josephsonelement (3) vorgesehen sind, so daß der jeweilige supraleitende Ring in den Streifenresonator (1) integriert ist, daß der Streifenresonator im Bereich der Öffnungen sowohl in Bezug auf die Öffnungen als auch in Bezug auf seine Mittel- bzw. Längsachse unsymmetrisch ausgebildet ist und daß zur kapazitiven Ankopplung des Streifenresonators (1) an eine Auswerteelektronik ein am Streifenresonator anliegendes weiteres Stück Streifenleitung (4) vorgesehen ist.

4. Schaltungsanordnung nach Anspruch 3,
**dadurch gekennzeichnet,**
daß die Öffnungen (2a, 2b) symmetrisch zur Mittel- bzw. Längsachse des Streifenresonators (1) angeordnet sind.

5. Schaltungsanordnung nach Anspruch 2 bis 4,
**dadurch gekennzeichnet,**
daß die elektrische Länge l des Streifenresonators (1) einem ungeraden Vielfachen der halben Wellenlänge der Betriebsfrequenz entspricht.

6. Schaltungsanordnung nach Anspruch 2 bis 5,
**dadurch gekennzeichnet,**
daß das Josephsonelement (3) an einer Stelle maximalen Stromflusses im Streifenresonator (1) angeordnet ist.

7. Schaltungsanordnung nach Anspruch 2 bis 6,
**dadurch gekennzeichnet,**
daß das weitere Stück Streifenleitung (4) in der Nähe eines im Streifenresonator (1) sich bildenden Spannungsbauches angeordnet ist.

FIG.1a

FIG.1b

FIG. 2a

FIG. 2b

FIG.2aa

FIG.2bb

FIG. 3

FIG. 4

FIG. 5

FIG.6